# EUROPEAN PATENT SPECIFICATION

(11) **EP 0 406 889 B1**
(45) Date of publication and mention of the grant of the patent: **23.04.1997**
(21) Application number: 90112942.9
(22) Date of filing: 06.07.1990
(51) Int. Cl.: H01L 21/339, H01L 21/441, H01L 27/148, H01L 29/43

(54) **Method of manufacturing a solid-state imaging device**
Verfahren zur Herstellung einer Festkörperbildaufnahmeanordnung
Procédé de fabrication d'un dispositif capteur d'images à l'état solide

(30) Priority: 06.07.1989 JP 175171/89; 17.11.1989 JP 299251/89
(43) Date of publication of application: 09.01.1991
(73) Proprietor: KABUSHIKI KAISHA TOSHIBA, Kawasaki-shi, Kanagawa-ken 210 (JP)
(72) Inventor: Maeda, Toru, 1-18, Toshiba Komukai Apartment, Kawasaki-shi, Kanagawa-ken (JP); Kawaguchi, Tatsuzo, Yokohama-shi, Kanagawa-ken (JP)
(74) Representative: Lehn, Werner, Dipl.-Ing.

(56) References cited:
- WO-A-88/07767
- PATENT ABSTRACTS OF JAPAN vol. 12, no. 369 (E-665)(3216) October 4, 1988 & JP-A- 63 120 463
- PATENT ABSTRACTS OF JAPAN vol. 5, no. 103 (E-064)July 3, 1981 & JP-A- 56 45 049
- PATENT ABSTRACTS OF JAPAN vol. 11, no. 031 (E-475)January 29, 1987 & JP-A- 61 198 774
- PATENT ABSTRACTS OF JAPAN vol. 13, no. 114 (E-730)(3462) March 20, 1989 & JP-A- 63 285 969
- S.P. Murarka, "Refractory silicides for integrated circuits" , J.Vac.Sci.Technol.17(4), July/Aug. 1980, p.775

## Description

The present invention relates to a solid-state imaging device and a method of manufacturing the same.

WO-A-88/07767 discloses a charge coupled device where a silicon oxide is first deposited on a semiconductor substrate. First-phase electrodes are then deposited on the semiconductor substrate and patterned, whereby first a doped polysilicon layer is deposited using a chemical vapour deposition technique. Subsequently, a sputtering of tungsten silicide results in the second layer of the first-phase electrodes. The resulting structure is patterned and heated whereby through the heat treatment a silicon oxide is deposited on the double layer structure of the first electrodes. The formation process for the first-phase electrodes is then repeated to deposit second-phase electrodes on top of the silicon oxide and the semiconductor substrate. Also the second-phase electrodes comprise a first layer of thin doped polysilicon and a second layer of sputtered tungsten silicide. Since the lower layers of the double layer structure are transparent and only the upper layer respectively acts as a light interruption means, the upper layer acting as charge transfer electrode is positioned far away from the substrate due to the interposing polysilicon opaque layer. This increases smear in the charge coupled device.

Likewise, Patent Abstracts of Japan, volume 5, number 103 (E-064) describe a pair of electrodes arranged on a semiconductor substrate. One electrode consists of a doped polysilicon layer underlying a MoSi₂-layer acting as the gate electrode. Also here the electrode acting layer is positioned far away from the semiconductor substrate and possesses the same disadvantages as afore-mentioned, namely the doped polysilicon layer is opaque, the electrode acting layer is positioned far away from the semiconductor substrate and the double layer structure has a large thickness.

Journal of Vacuum Science and Technology, Vol. 17(4), July/August 1980, p. 775-792 discusses the formation of refractory metal silicides.

### BACKGROUND OF THE INVENTION

### (Description of the Prior Art)

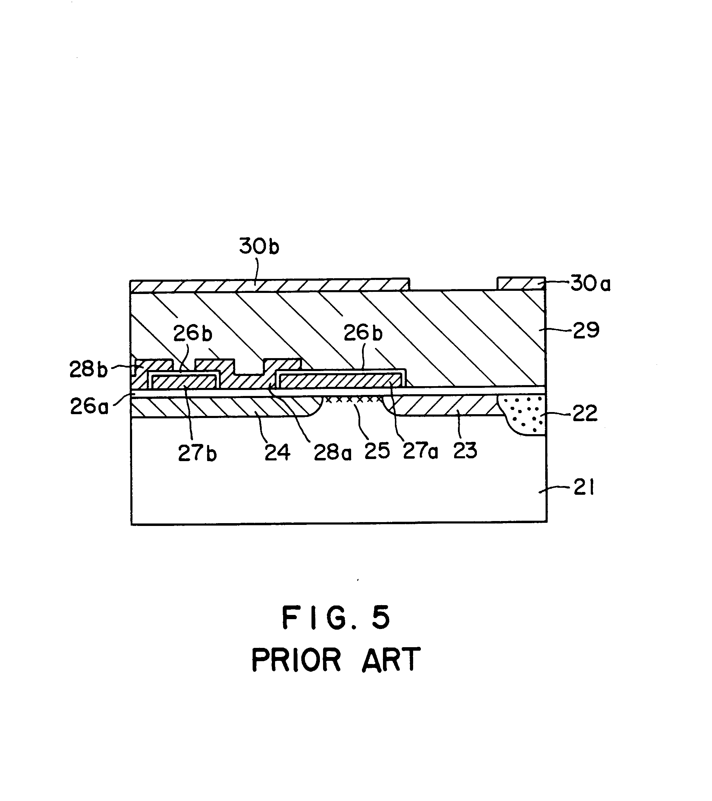

The structure of a conventional solid-state imaging device will be described below with reference to the device shown in Fig. 5. First, a specific region of a semiconductor substrate (hereinafter abbreviated to substrate) 21 is implanted with an impurity of the same conductivity type as that of the substrate 21 to form an impurity region 22 that will isolate elements. Then, using an impurity of a different conductivity type from that of the substrate 21, a light-sensitive element region 23 and a charge transfer region 24 are separately formed in specific regions of the substrate 21. A channel region 25 implanted with a specific impurity is formed in the region of the substrate 21 between the regions 23 and 24. The structure of this channel region 25 is such that it determines the characteristics of a transistor formed by the substrate 21, regions 23 and 24, and an electrode 27a (described below).

Next, after an oxidation film 26a has been formed over the entire surface, a low-resistance polysilicon to which an impurity has been added is deposited thereon, and electrodes 27a and 27b are formed in the polysilicon by patterning. Subsequently, an insulation oxidation film 26b is formed over the top and sides of the low-resistance polysilicon by thermal oxidation.

Low-resistance polysilicon is then deposited and patterned to form electrodes 28a and 28b. After an insulating film 29 of, for instance, PSG, is formed thickly over the entire surface by a vapor growth method, a light-proof film consisting of aluminum is deposited thereon. Part of the light-proof film corresponding to the light-sensitive element region 23 is removed by patterning, exposing a hole portion corresponding to the light-sensitive element region 23 while leaving light-proof films 30a and 30b on the insulating film 29, covering the regions outside the portion corresponding to the light-sensitive element region 23.

In the solid-state imaging device constructed as described above, electric charge due to light incident on the hole portion defined by the light-proof films 30a and 30b is accumulated in the light-sensitive element formed by the substrate 21 and the light-sensitive element region 23. The transistor formed by the regions 23 and 24 and the electrode 27a operates so that the charge accumulated in the light-sensitive element is read out by the electrode 27a in the charge transfer region 24. A voltage differential is created between the electrodes 27a, 28a, 27b, and 28b, transferring the charge in sequence from right to left (as seen in the figure) within the charge transfer region 24.

### (Problems To Be Solved by the Present Invention)

The above conventional solid-state imaging device has the following problems:
1. Since there is a lower limit on the resistance of the polysilicon used to form the electrodes 27a, 28a, 27b, and 28b that transfer the charge, it takes a long time to transfer a charge in a solid-state imaging device consisting of several elements.
2. Since the insulating film 29 isolating the electrodes 27a, 28a, 27b, and 28b from the light-proof films 30a and 30b is thick, unwanted light such as that incident at an angle through the hole in the light-proof film and reflected light can enter the charge transfer region 24 via the semi-transparent electrodes 27a, 28a, 27b, and 28b, without passing through the light-sensitive element region 23, causing smear noise that will also transfer charge.
3. The first layer of charge transfer electrodes 27a and 27b is insulated from the second layer of charge transfer electrodes 28a and 28b by the oxidation film 26a formed by thermal oxidation, but the dielectric strength of this oxidation film 26a is unstable, so variations in controllability can occur.

### SUMMARY OF THE INVENTION

The present invention is designed to solve the above problems. It provides a solid-state imaging device that is both capable of high-speed operation and prevents the occurrence of smear noise, as far as is possible, and a manufacturing method that can produce such a solid-state imaging device.

According to the method of manufacturing a solid-state imaging device of the present invention constructed as described above, first charge transfer electrodes are formed by subjecting the patterned film including at least the alloy of the high-melting-point metal and silicon to high-temperature processing in a specific atmosphere to turn into a silicide, then the top and sides of the film of the silicide of the high-melting-point metal are covered by an inter-layer insulating film made of SiO₂. The same process is repeated to form second charge transfer electrodes. Compared with conventional polysilicon electrodes, the electrodes formed in this way have a lower resistance and are impermeable to visible light, so the electrodes enable faster operation than conventional electrodes and, since the electrodes themselves act as a light-proof film, the electrodes can prevent the occurrence of smear noise, as far as is possible. In addition, since the SiO₂ inter-layer insulation film between the first and second charge transfer electrodes, consisting of the alloy of a high melting point metal and silicon, has a two-layer structure, it is more stable than the conventional equivalent, so controllability of the solid-state imaging device is better.

According to the solid-state imaging device of the present invention, it is possible to provide a highly efficient solid-state imaging device which can operate at high speeds and prevent the occurrence of smear noise, as far as is possible, and which is also extremely controllable.

### BRIEF DESCRIPTION OF THE DRAWINGS

Figs. 1A to 1D are sectional views showing the process of manufacturing the solid-state imaging device of the present invention;
Figs. 2A to 2D are sectional views showing a process of manufacturing a solid-state imaging device;
Figs. 3 and 4 are graphs showing the effects of the solid-state imaging device of the present invention; and
Fig. 5 is a sectional view of a conventional solid-state imaging device.

### DESCRIPTION OF THE PREFERRED EMBODIMENTS

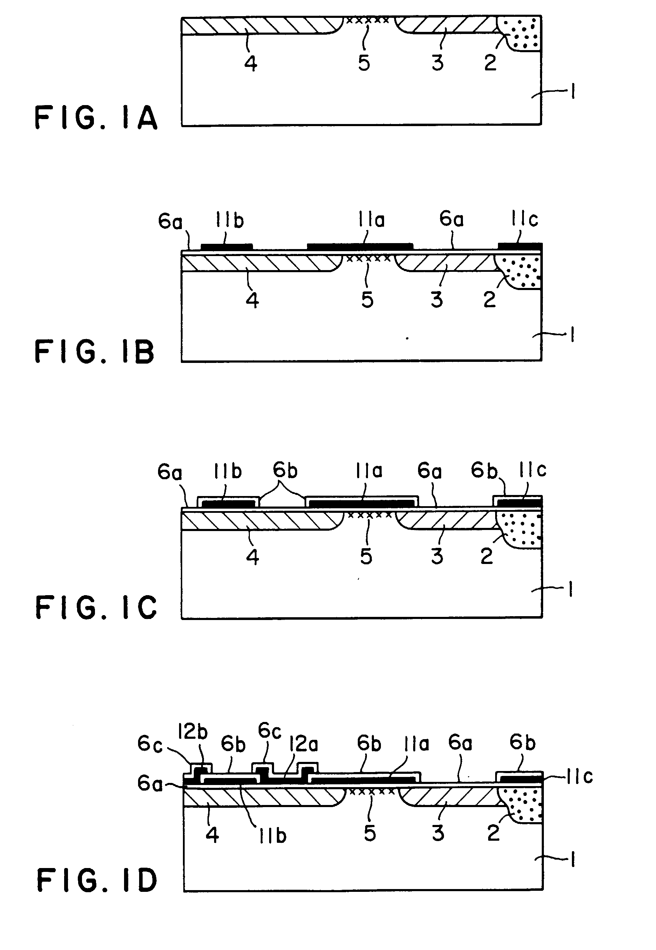

The process of manufacturing the solid-state imaging device of the present invention is shown in Figs. 1A through 1D. As shown in Fig. 1A, an impurity is implanted into specific regions of a semiconductor substrate (hereinafter abbreviated to substrate) 1 of a first conductivity type (for example, P-type) to form a light-sensitive element region 3 and a charge transfer region 4 of a second conductivity type (for example, N-type), and an impurity of the same conductivity type as the substrate 1 is implanted into the region surrounding the light-sensitive element region 3, except for a channel region 5 that will be described below, to form an element isolation region 2 to isolate adjacent elements. Then a specific impurity is implanted into the region of the substrate 1 between regions 3 and 4 to form the channel region 5 (see Fig. 1A).

Next, after a gate oxidation film 6a is formed over the entire surface, a film formed from an alloy of tungsten and silicon is deposited and patterned to form charge transfer electrodes 11a and 11b and a light-proof film 11c (see Fig. 1B). The charge transfer electrodes 11a and 11b and the light-proof film 11c formed of this tungsten-silicon alloy are then subjected to high-temperature processing in an atmosphere of O₂ to turn the metal into its silicide, and an inter-layer insulation film 6b formed of SiO₂ is grown up on the top and sides of the processed charge transfer electrodes 11a and 11b and the light-proof film 11c (see Fig. 1C). Note that the component 11c on the element isolation region 2 is not used as an electrode; it functions as a light-proof film. Another film of tungsten-silicon alloy is then deposited and patterned to form a second layer of charge transfer electrodes 12a and 12b (see Fig. 1D). In the same way as with the first layer of charge transfer electrodes 11a and 11b, the second layer of charge transfer electrodes 12a and 12b is subjected to high-temperature processing in an atmosphere of O₂ to turn the metal of the electrodes 12a and 12b into its silicide, and an inter-layer insulation film 6c formed of SiO₂ is grown up on the top and sides of the processed charge transfer electrodes 12a and 12b, then the solid-state imaging device is completed by forming wiring. Depending on the eventual application of the solid-state imaging device, a protecting film could subsequently be formed over the entire surface.

Instead of using a tungsten-silicon alloy as the material of the electrodes 11a, 11a', 11b, 11b', 11c, 11c', 12a, 12a', 12b and 12b', any high-melting-point metal silicide that has a low resistance and high heat tolerance can be used. In other words, in place of a tungsten-silicon alloy, a molybdenum-silicon alloy or a tantalum-silicon alloy could be used.

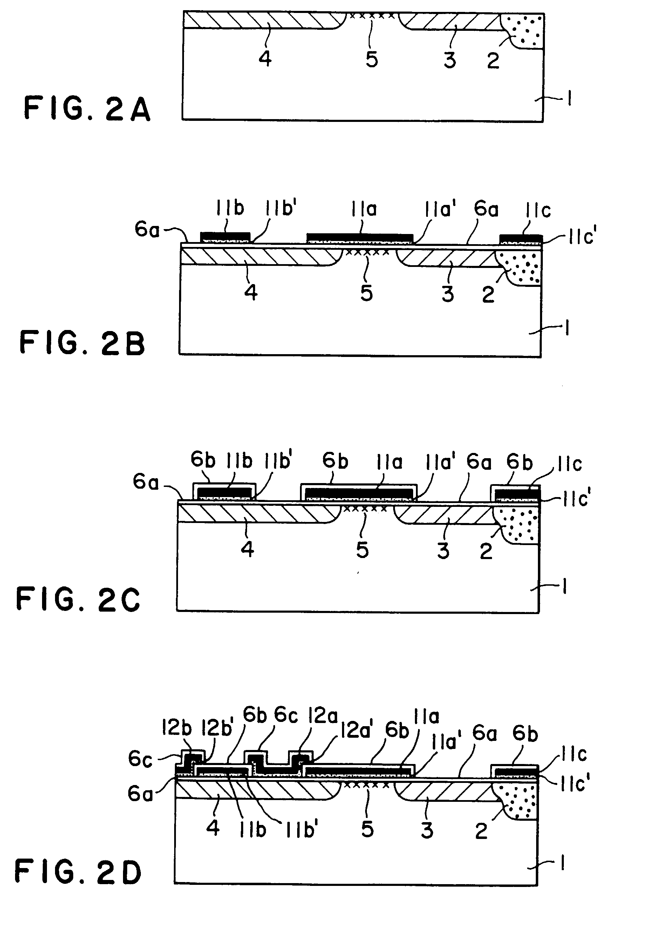

In the above embodiment, the first layer of charge transfer electrodes 11a and 11b, and the second layer of charge transfer electrodes 12a and 12b are formed directly on top of the gate oxidation film 6a. It is also possible to form these layers by sequentially depositing and patterning a film for the electrode 11a of an alloy consisting of a high-melting-point metal (for example tungsten) and silicon, and a polysilicon film with an impurity on top of the gate oxidation film 6a, as shown in Figs. 2A-2D.

In Fig. 2A, an impurity is implanted to a predetermined region of the substrate 1 of the first conductivity type (for example, P-type) to form the light-sensitive element region 3 of the second conductivity type (for example, N-type) and the charge transfer region 4 of the second conductivity type, and the element isolation region 2, which is formed by implanting an impurity having the same conductivity type as the substrate 1, is formed at the surrounding region in the light-sensitive region except the channel region to isolate adjacent elements. Then the specific impurity is implanted into the region of the substrate 1 between regions 3 and 4 to form the channel region 5.

Next, after the gate oxidation film 6a is formed over the entire surface, the polysilicon film with the impurity and the film of the alloy consisting of tungsten and silicon are sequentially deposited and patterned to form the charge transfer electrodes 11a, 11a', 11b and 11b' and the light-proof films 11c and 11c' (see Fig. 2B). The charge transfer electrodes 11a and 11b and the light-proof film 11c formed of the tungsten-silicon alloy are then subjected to high-temperature processing in an atmosphere of O₂ to turn the metal into its silicide, and the inter-layer insulation film 6b formed of SiO₂ is grown up on the top and sides of the processed charge transfer electrodes 11a, 11b and the light-proof film 11c and the polysilicon films of the charge transfer electrodes 11a' and 11b' and the sides of the polysilicon film of the light-proof film 11c' (see Fig. 2C). Note that the component 11c on the element isolation region 2 is not used as an electrode; it functions as a light-proof film. Another polysilicon film with the impurity and another film of tungsten-silicon alloy are then deposited and patterned to form the second layer of the charge transfer electrodes 12a, 12a', 12b and 12b' on the charge transfer electrodes 11a, 11a', 11b and 11b' (see Fig. 2D).

In the same way as with the first layer of the charge transfer electrodes 11a, 11a', 11b and 11b', the second layer of the charge transfer electrodes 12a and 12b is subjected to high-temperature processing in an atmosphere of O₂ to turn the metal of the electrodes 12a and 12b into its silicide, and the inter-layer insulation film 6c formed of SiO₂ is grown up on the top and sides of the processed charge transfer electrodes 12a and 12b, then the solid-state imaging device is completed by forming wiring. An additional protecting film can be formed over the entire device depending upon its uses.

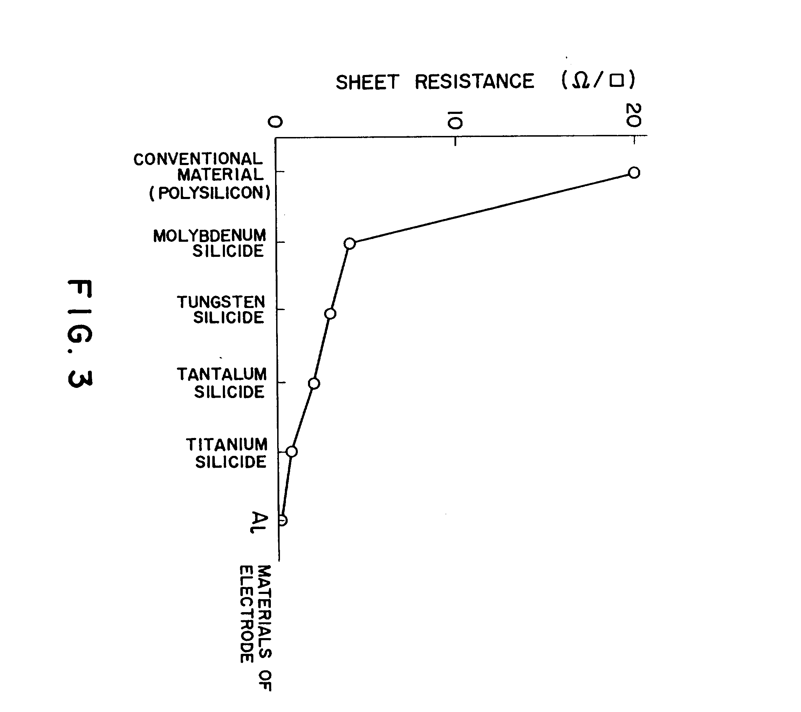

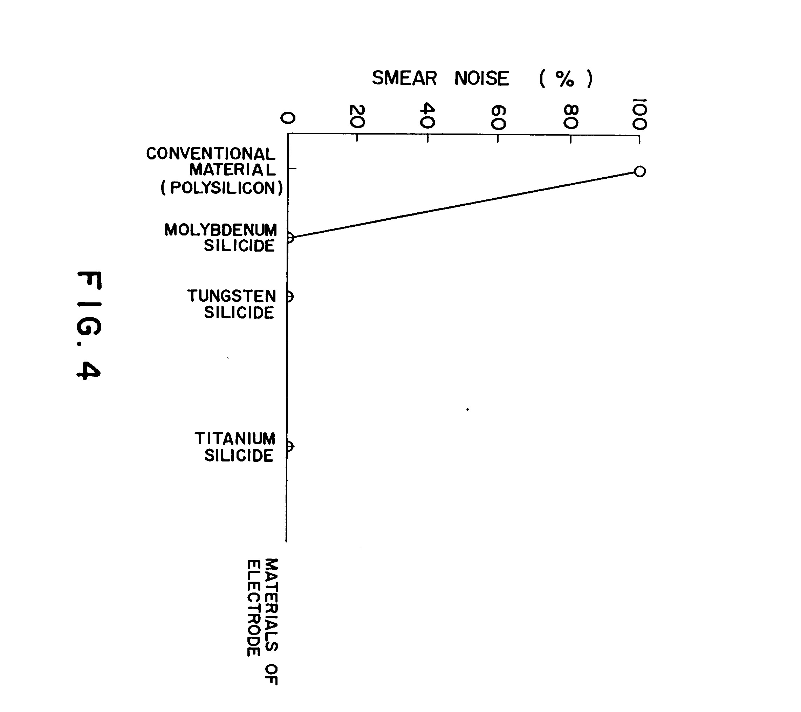

The solid-state imaging devices shown in Figs. 1D and 2D and constructed as described above have the following advantages:
1. The resistance of the charge transfer electrodes can be reduced to one-fifth to one-twentieth that of a conventional device, as shown in Fig. 3, enabling high-speed operation.
2. The charge transfer electrodes themselves act as a light-proof film to block light, so that light can be completely prevented from shining on parts of the device outside the light-sensitive element, enabling the prevention of smear noise, as shown in Fig. 4.
3. Since the charge transfer electrodes 12a and 12b themselves form light-proof films, the special-purpose light-proof films 30a and 30b and the inter-layer insulating film 29 of the conventional solid-state imaging device are not necessary, reducing the number of construction steps required to two-thirds that of a conventional device, which can be expected to improve yield and reliability of the device.
4. Since the inter-layer insulation film 6b between the first layer of charge transfer electrodes 11a, 11a', 11b and 11b' and the second layer of charge transfer electrodes 12a, 12a', 12b and 12b' is formed as two layers, the device is more stable than the conventional device of Fig.5, and its controllability is better.

In the above embodiment, the light-sensitive element region 3 is formed before the charge transfer electrodes 11a, 11a', 11b, 11b', 12a, 12a', 12b and 12b' are formed, but it can also be formed by a self-alignment method after the charge transfer electrodes are formed.

With this structure, the individual charge transfer electrodes of the first layer are electrically connected to each other by the polysilicon, even if they should become damaged.

## Claims

1. A method for manufacturing a solid-state imaging device, comprising the following steps:
a) separately forming a light-sensitive element region (3) and a charge transfer region (4) in a semiconductor substrate (1) of a first conductivity type (P) by implanting an impurity of a second conductivity type (N) into specific regions of said semiconductor substrate (1);
b) forming an element isolation region (2) by implanting an impurity of said first conductivity type (P) into a region of said semiconductor substrate (1) surrounding said light-sensitive element region (3) except for a region between said light-sensitive element region (3) and said charge transfer region (4);
c) forming a channel region (5) by implanting an impurity of said first conductivity type (P) into said region of said semiconductor substrate (1) between said light-sensitive element region (3) and said charge transfer region (4);
d) forming a gate insulation film (6a) over the entire resulting surface of said semiconductor substrate (1);
e) forming a first alloy film of a high melting point metal of tungsten, molybdenum or tantalum and silicon directly on said gate insulation film (6a) and patterning said first alloy film to form first charge transfer electrodes (11a, 11b) in regions overlying said charge transfer region (4) and said channel region (5) and a light-proof film (11c) in a region overlying said element isolation region (2);
f) subjecting the resulting structure to a high temperature processing in an oxidizing atmosphere of O₂ to turn said high melting point metal of said first charge transfer electrodes (11a, 11b) and said light-proof film (11c) into their silicide, and
g) to form a first inter-layer insulation film (6b) of SiO₂ on top and side surfaces of said processed first charge transfer electrodes (11a, 11b) and said light-proof film (11);
h) forming a second alloy film of a high melting point metal of tungsten, molybdenum or tantalum and silicon directly on the resulting structure and patterning said second alloy film to form second charge transfer electrodes (12a, 12b) in regions of said charge transfer region (4) with portions thereof partially overlapping said first charge transfer electrodes (11a, 11b);
i) subjecting the resulting structure to a high temperature processing in an oxidizing atmosphere of O₂ to turn said high melting point metal of said second charge transfer electrodes (12a, 12b) into its silicide, and
j) to form a second inter-layer insulation film (6c) of SiO₂ on top and side surfaces of said processed second charge transfer electrodes (12a, 12b).

2. A method according to claim 1,
***characterized in that***
a protecting film is formed over the resultant structure after step j).

## Patentansprüche

1. Verfahren zum Herstellen einer Festkörper-Abbildungsvorrichtung, das folgende Schritte aufweist:
a) separates Ausbilden eines lichtempfindlichen Elementenbereichs (3) und eines Ladungsübertragungsbereichs (4) in einem Halbleitersubstrat (1) eines ersten Leitfähigkeitstyps (P) durch Implantieren von Framdatomen eines zweiten Leitfähigkeitstyps (N) in spezifische Bereiche des Halbleitersubstrats (1);
b) Ausbilden eines Elementen-Isolationsbereichs (2) durch Implantieren von Framdatomen des ersten Leitfähigkeitstyps (P) in einen Bereich des Halbleitersubstrats (1), der den lichtempfindlichen Elementenbereich (3) umgibt, außer für einen Bereich zwischen dem lichtempfindlichen Elementenbereich (3) und dem Ladungsübertragungsbereich (4);
c) Ausbilden eines Kanalbereichs (5) durch Implantieren von Framdatomen des ersten Leitfähigkeitstyps (P) in den Bereich des Halbleitersubstrats (1) zwischen dem lichtempfindlichen Elementenbereich (3) und dem Ladungsübertragungsbereich (4) ;
d) Ausbilden eines Gate-Isolierfilms (6a) über der gesamten resultierenden Oberfläche des Halbleitersubstrats (1);
e) Ausbilden eines ersten Legierungsfilms eines Metalls mit hohem Schmelzpunkt aus Wolfram, Molybdän oder Tantal und Silizium direkt auf dem Gate-Isolierfilm (6a) und Mustern des ersten Legierungsfilms, um erste Ladungsübertragungselektroden (11a, 11b) in Bereichen auszubilden, die über dem Ladungsübertragungsbereich (4) und dem Kanalbereich (5) liegen, und eines lichtundurchlässigen Films (11c) in einem Bereich, der über dem Elementen-Isolationsbereich (2) liegt;
f) Unterziehen der resultierenden Struktur einer Hochtemperaturverarbeitung in einer oxidierenden O₂-Atmosphäre, um das Metall mit hohem Schmelzpunkt der ersten Ladungsübertragungselektrode (11a, 11b) und des lichtundurchlässigen Films (11c) in ihre Silizide umzuwandeln, und
g) um einen ersten Zwischenschichten-Isolationsfilm (6b) aus SiO₂ auf der oberen Seite und den Seitenoberflächen der verarbeiteten ersten Ladungsübertragungselektrode (11a, 11b) und dem lichtundurchlässigen Film (11) auszubilden;
h) Ausbilden eines zweiten Legierungsfilms aus einem Metall mit hohem Schmelzpunkt aus Wolfram, Molybdän oder Tantal und Silizium direkt auf der resultierenden Struktur und Mustern des zweiten Legierungsfilms, um zweite Ladungsübertragungselektroden (12a, 12b) in Bereichen des Ladungsübertragungsbereichs (4) auszubilden, wobei Teile davon die ersten Ladungsübertragungselektroden (11a, 11b) teilweise überlagern;
i) Unterziehen der resultierenden Struktur einer Hochtemperaturverarbeitung in einer oxidierenden O₂-Atmosphäre, um das Metall mit hohem Schmelzpunkt der zweiten Ladungsübertragungselektroden (12a, 12b) in sein Silizid umzuwandeln, und
j) um einen zweiten Zwischenschichten-Isolierfilm (6c) aus SiO₂ auf der oberen Seite und den Seitenoberflächen der verarbeiteten zweiten Ladungsübertragungselektroden (12a, 12b) auszubilden.

2. Verfahren nach Anspruch 1,
dadurch gekennzeichnet, daß
nach dem Schritt j) ein Schutzfilm über der resultierenden Struktur ausgebildet wird.

## Revendications

1. Procédé de fabrication d'un dispositif imageur à l'état solide comprenant les phases suivantes qui consistent à :
a) former séparément une région (3) d'élément photosensible et une région (4) de transfert de charge dans un substrat semi-conducteur (1) d'un premier type de conductivité (P) en implantant une impureté d'un deuxième type de conductivité (N) dans des régions spécifiques dudit substrat semi-conducteur (1);
b) former une région (2) d'isolement de l'élément en implantant une impureté dudit premier type de conductivité (P) dans une région dudit substrat semi-conducteur (1) qui entoure ladite région (3) d'élément photosensible, à l'exception d'une région située entre ladite région (3) d'élément photosensible et ladite région (4) de transfert de charge ;
c) former une région canal (5) en implantant une impureté dudit premier type de conductivité (P) dans ladite région dudit substrat semi-conducteur (1) entre ladite région (3) d'élément photosensible et ladite région (4) de transfert de charge ;
d) former un film (6a) d'isolation de porte sur toute la surface résultante dudit substrat semi-conducteur (1);
e) former un premier film d'alliage composé d'un métal à haut point de fusion, tungstène, molybdène ou tantale, et de silicium directement sur ledit film (6a) d'isolation de porte et façonner ledit premier film d'alliage pour former des premières électrodes (11a, 11b) de transfert de charge dans des régions qui recouvrent ladite région (4) de transfert de charge et ladite région canal (5), et un film (11c) étanche à la lumière dans une région qui recouvre ladite région (2) d'isolation de l'élément ;
f) soumettre la structure résultante à un traitement à haute température dans une atmosphère oxydante de O₂ pour transformer ledit métal à haut point de fusion desdites premières électrodes de transfert de charge (11a, 11b) et dudit film (11c) étanche à la lumière en leur siliciure, et
g) former un premier film (6b) d'isolation inter-couches en SiO₂ sur les surfaces supérieure et latérales desdites premières électrodes (11a, 11b) de transfert de charge traitées et ledit film (11) étanche à la lumière ;
h) former un deuxième film d'alliage composé d'un métal haut point de fusion, tungstène, molybdène ou tantale, et de silicium directement sur la structure résultante et façonner ledit deuxième film d'alliage pour former des deuxièmes électrodes (12a, 12b) de transfert de charge dans des régions de ladite région (4) de transfert de charge, de façon que des parties de ces électrodes recouvrent partiellement lesdites premières électrodes (11a, 11b) de transfert de charge ;
i) soumettre la structure résultante à un traitement à haute température dans une atmosphère oxydante de O₂ pour transformer ledit métal à haut point de fusion desdites deuxièmes électrodes (12a, 12b) de transfert de charge en son siliciure ; et
j) former un deuxième film (6c) d'isolation de SiO₂ entre couches sur la surface supérieure et les surfaces latérales desdites deuxièmes électrodes (12a, 12b) de transfert de charge traitées.

2. Procédé selon la revendication 1, caractérisé en ce qu'on forme un film protecteur sur la structure résultante après la phase j).
